# FASCICULE DE BREVET EUROPEEN

(11) **EP 3 583 267 B1**
(45) Date de publication et mention de la délivrance du brevet: **09.12.2020**
(21) Numéro de dépôt: 18706830.9
(22) Date de dépôt: 15.02.2018
(51) Int. Cl.: E01F 9/559

(54) **DALLE DE SIGNALISATION LUMINEUSE ET SYSTÈME POUVANT UTILISER UNE TELLE DALLE**
LICHTSIGNALISIERUNGSSPLATTE UND ZUR VERWENDUNG SOLCH EINER PLATTE FÄHIGES SYSTEM
LIGHT SIGNALLING PLATE AND SYSTEM CAPABLE OF USING SUCH A PLATE

(30) Priorité: 17.02.2017 FR 1751311; 02.10.2017 FR 1759200
(43) Date de publication de la demande: 25.12.2019
(73) Titulaire: Commissariat à l'Energie Atomique et aux Energies Alternatives, 75015 Paris (FR); COLAS, 75015 Paris (FR)
(72) Inventeur: DE BETTIGNIES, Rémi, 73377 Le Bourget Du Lac (FR); BARRUEL, Franck, 73370 Le Bourget Du Lac (FR); GUILLEREZ, Stéphane, 73610 Lepin Le Lac (FR); COQUELLE, Eric, 78000 Versailles (FR); SOULIMA, Valérian, 73000 Chambery (FR); CHAINTREUIL, Nicolas, 73800 Montmelian (FR); THERME, Jean, 73230 Saint Jean D'Arvey (FR)
(74) Mandataire: Jacobacci Coralis Harle
(86) Numéro de dépôt international: PCT/FR2018/050368
(87) Numéro de publication internationale: WO 2018/150144

(56) Documents cités:
- WO-A1-2016/016165
- WO-A1-2016/016484
- ES-U- 1 076 871

## Description

### Domaine technique de l'invention

La présente invention se rapporte à une dalle de signalisation lumineuse.

L'invention peut être mise en œuvre pour de nombreuses applications, qui requièrent notamment des éléments fins, flexibles et/ou particulièrement robustes pour supporter des chocs, des charges mécaniques importantes ou pour résister au vandalisme.

Elle trouve ainsi une application privilégiée, mais non limitative, sur des zones accueillant des piétons, des vélos ou tous types de véhicules, par exemple des chaussées, trottoirs, quais de gare entre autres.

L'invention se rapporte également à un système pouvant utiliser une telle dalle lumineuse.

Le système pourra être un système de passage pour piétons. Ce système comporte notamment des zones photovoltaïques et des zones de signalisation dotées de moyens d'éclairage alimentés par l'énergie électrique récupérée grâce aux zones photovoltaïques. De manière non limitative, les zones de signalisation pourront être mises en œuvre en employant une ou plusieurs desdites dalles de signalisation lumineuses.

### Etat de la technique

Il existe beaucoup de solutions d'éclairage, proposant des boitiers lumineux à encastrer dans un logement réalisé dans un mur ou dans une chaussée. C'est par exemple le cas de la solution décrite dans la demande de brevet CN201382393U ou dans la demande de brevet EP2803911A1**.**

La demande de brevet WO2016/016484A1 propose pour sa part une solution Intégrée à la chaussée et venant prolonger les bandes blanches d'un passage pour piétons, permettant ainsi de renforcer la signalisation autour de la zone piétonne.

Beaucoup d'autres solutions ont été proposées pour signaler ou avertir en utilisant des blocs lumineux intégrés à la route.

Cependant, la plupart des solutions connues proposent des blocs lumineux de forte épaisseur. Certes, cette forte épaisseur peut rendre le bloc plus robuste et plus résistant aux contraintes mécaniques mais son installation peut s'avérer plus difficile, nécessitant souvent des travaux d'infrastructure.

De plus, de par leur taille et leurs caractéristiques, ces blocs lumineux sont limités à un usage ponctuel et ne présentent ni les caractéristiques mécaniques, ni les caractéristiques d'adhérence requises pour un usage sous trafic, ni la capacité à résister au vandalisme.

Lorsqu'une zone de signalisation lumineuse est intégrée directement à la route pour alerter de la présence d'une zone de danger, l'architecture de signalisation lumineuse doit cependant présenter une fiabilité à toute épreuve. Cette architecture doit présenter des qualités de :
- Fiabilité pour fonctionner quelles que soient les contraintes mécaniques ou climatiques ;
- Résistance mécanique pour résister au trafic piétonnier, cycliste, ou automobile de tous types ;
- Flexibilité pour être facilement positionnée sur une couche plane ou non ;
- Adhérence pour recréer les caractéristiques de rugosité d'une zone circulable classique telle qu'une chaussée ;
- Finesse pour notamment permettre sa flexibilité, limiter l'encombrement en hauteur, être facilement positionnable sur une chaussée existante sans modification ni travaux conséquents ;
- Visibilité pour toujours assurer une signalisation, quelles que soient les conditions atmosphériques, notamment en cas de brouillard ou de pluie ;

Un but de l'invention est donc de proposer une dalle de signalisation lumineuse formant au moins partiellement une zone circulable et présentant les qualités décrites ci-dessus.

### Exposé de l'invention

Ce but est atteint par une dalle de signalisation lumineuse monobloc comprenant une structure à plusieurs couches superposées et fixées entre elles, ladite structure comportant :
- Une première couche transparente ou translucide formant une face avant de ladite dalle ;
- Un ensemble lumineux comprenant une pluralité de diodes électroluminescentes reliées électriquement entre elles ;
- Un ensemble encapsulant ladite pluralité diodes électroluminescentes ;
- Une deuxième couche formant une face arrière de ladite dalle et composée d'un matériau composite polymère/fibres de verre ;
- Ledit ensemble encapsulant étant positionné entre ladite première couche et ladite deuxième couche.

Selon une particularité, chaque plaque de la première couche est positionnée en vis-à-vis d'au moins une diode électroluminescente.

Selon une autre particularité, la première couche est réalisée dans un matériau de type polymère choisi parmi le polycarbonate, le polyméthacrylate de méthyle, l'éthylène tétrafluoroéthylène et le polyfluorure de vinylidène.

Selon une autre particularité, la première couche présente une épaisseur supérieure à 100 µm, avantageusement comprise entre 200 µm et 3200 µm et de préférence entre 400 µm et 750 µm.

Selon une autre particularité, la deuxième couche présente une rigidité définie par un module de Young à température ambiante supérieur à 1 GPa.

Selon une autre particularité, ladite deuxième couche comporte une épaisseur comprise entre 0.3 mm et 3 mm.

Selon une autre particularité, les diodes électroluminescentes sont organisées en ruban déposé sur la deuxième couche ou sur un support, ou sont connectées sur une carte de circuit imprimé.

Selon une autre particularité, ladite deuxième couche est réalisée sous la forme d'une carte de circuit imprimé sur laquelle sont connectées directement lesdites diodes électroluminescentes.

Selon une autre particularité, l'ensemble encapsulant est réalisé dans un matériau présentant un module de Young à température ambiante supérieur à 50 MPa.

Selon une autre particularité, ledit ensemble encapsulant présente une épaisseur comprise entre 100 µm et 4 mm et avantageusement comprise entre 250 µm et 1 mm.

Selon une autre particularité, la structure multicouches comporte au moins une couche intermédiaire, agencée entre ladite première couche et l'ensemble encapsulant et configurée pour réaliser l'assemblage par collage de ladite première couche sur l'ensemble encapsulant.

Selon une autre particularité, ladite couche intermédiaire est réalisée dans un ou plusieurs matériaux choisis parmi une polyoléfine, des polymères de type caoutchouc, élastomère ou époxy.

Selon une autre particularité, la couche intermédiaire est configurée pour présenter un module de Young à température ambiante inférieur ou égal à 100 MPa.

Selon une autre particularité, ladite couche intermédiaire comporte une épaisseur comprise entre 200 µm et 1600 µm.

Selon une autre particularité, ladite structure comporte une couche adhésive située en face arrière, en contact avec la deuxième couche.

Selon une autre particularité, ladite structure comporte une couche de roulement appliquée sur ladite première couche, ladite couche de roulement étant non opaque et présentant une surface texturée et irrégulière.

L'invention concerne également un système comprenant une zone circulable dotée d'une couche de support, ledit système comportant une ou plusieurs dalles de signalisation lumineuse telles que définie ci-dessus, fixées sur ladite couche de support, chaque dalle étant positionnée de manière à former un marquage sur ladite zone circulable lorsque leur ensemble lumineux est allumé.

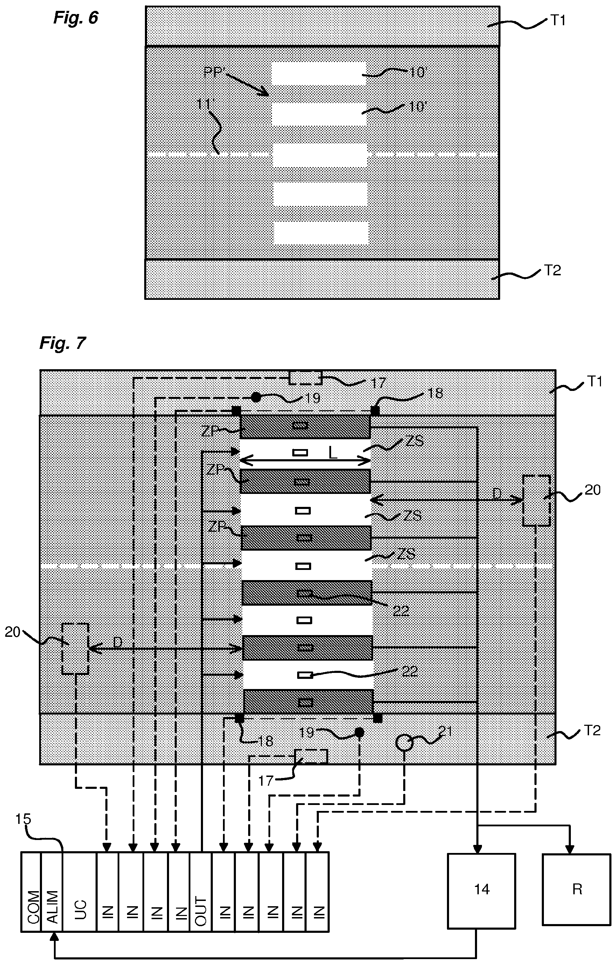

Comme représenté sur la figure 6, un tel marquage peut former un passage pour piétons. Un passage pour piétons se compose de plusieurs bandes blanches parallèles peintes sur la chaussée et disposées à intervalles réguliers sur toute la largeur de la chaussée à traverser.

Ces passages pour piétons doivent être régulièrement entretenus pour rester visibles pour les conducteurs de véhicules. Avec le temps, il peut cependant s'avérer que les bandes blanches des passages pour piétons s'abiment et deviennent de moins en moins contrastées avec le reste de la chaussée, les rendant moins visibles pour les conducteurs à faible ou forte luminosité extérieure.

Dans certaines zones, notamment aux abords des écoles, dans des zones commerciales ou lors de manifestations, la multiplication du nombre de véhicules en circulation peut nécessiter un renfort de la sécurité pour permettre aux piétons de traverser une route de manière sécurisée. Aux abords des écoles, il s'agit par exemple d'employer du personnel dédié pour aider les enfants à traverser. Cependant, il n'est pas possible de prévoir du personnel toute une journée et notamment la nuit.

Il existe des panneaux, notamment lumineux, qui permettent d'avertir les véhicules de la proximité d'un passage pour piétons. Cependant, leur positionnement en amont des passages pour piétons n'avertit pas forcément le véhicule qu'il est nécessaire de ralentir. De plus, ces panneaux nécessitent souvent d'être alimentés en électricité.

Par ailleurs, la demande de brevet US2005/270175A1**,** la demande de brevet FR3020645A1 et la demande de brevet FR2790060A1 décrivent différentes solutions de signalisation, utilisées dans le cadre de systèmes de passage pour piétons. Cependant, ces solutions sont souvent de simples dispositifs venant s'ajouter aux passages pour piétons classiques. Elles ne sont donc pas complètement intégrées à l'infrastructure routière et viennent ainsi surcharger la zone formée par le passage pour piétons, risquant de perturber les conducteurs à l'approche de la zone de danger.

Il existe donc également un besoin d'un système de passage pour piétons qui :
- Reste visible sur le long terme, notamment en cas de faible ou forte luminosité, et même en l'absence d'un entretien régulier ;
- Permette d'avertir les conducteurs de manière visible qu'un piéton s'apprête à traverser sur le passage pour piétons ;
- Soit facile à installer et peu encombrant ;
- Ne surcharge pas l'infrastructure, afin de ne pas perturber les conducteurs à l'approche de la zone ;
- Puisse facilement s'adapter à différents types de contraintes, notamment de lieu, de luminosité ou au public destiné à traverser,...

Ce besoin peut être comblé par un système de passage pour piétons, comprenant une zone circulable destinée à être positionnée sur une chaussée pour former un passage pour piétons comprenant plusieurs bandes de signalisation, ledit système présentant les particularités suivantes :
- La zone circulable comporte plusieurs zones photovoltaïques comprenant des cellules photovoltaïques destinées à capter une énergie lumineuse pour la convertir en une énergie électrique ;
- La zone circulable comporte plusieurs zones de signalisation, de surfaces non nulles, au moins deux d'entre elles étant séparées par une zone photovoltaïque de manière à former lesdites plusieurs bandes de signalisation du passage pour piétons, chaque zone de signalisation intégrant des moyens électriques d'éclairage ;
- Un système de commande desdits moyens électriques d'éclairage ;
- Au moins une unité de stockage de l'énergie électrique générée par chaque zone photovoltaïque et connectée auxdits moyens électriques d'éclairage pour les alimenter en énergie électrique ;
- Des moyens de détection de présence ;
- Une unité de traitement et de commande comprenant au moins une entrée connectée audits moyens de détection de présence et au moins une sortie connectée audit système de commande ;

Selon une particularité de ce système :
- Chaque zone photovoltaïque est composée d'au moins une dalle ;
- Chaque zone de signalisation est composée d'au moins une dalle ;
- Les dalles formant les zones photovoltaïques et les zones de signalisation sont positionnées de manière adjacente et jointive afin de former une couche fonctionnelle sur toute ladite zone circulable.

De manière non limitative, le système de passage pour piétons pourra notamment employer, pour chacune de ses zones de signalisation, une ou plusieurs dalles de signalisation lumineuse ayant la configuration particulière définie ci-dessus et faisant l'objet de l'invention.

Selon une autre particularité, ladite au moins une dalle formant chaque zone photovoltaïque et ladite au moins une dalle formant chaque zone de signalisation présentent des épaisseurs identiques.

Selon une autre particularité, les moyens électriques d'éclairage d'une zone de signalisation comportent des diodes électroluminescentes.

Selon une autre particularité, les diodes électroluminescentes sont agencées pour délimiter la surface de la bande à laquelle elles appartiennent.

Selon une autre particularité, les diodes électroluminescentes sont réparties de manière régulière pour éclairer toute la zone de signalisation.

Selon une autre particularité, la zone de signalisation comporte une structure multicouches.

Selon une autre particularité, ladite structure multicouches comporte au moins une couche transparente permettant de laisser passer un flux lumineux et un boîtier dans lequel sont encapsulées lesdites diodes électroluminescentes.

Selon une autre particularité, chaque zone photovoltaïque comporte une structure multicouches.

Selon une autre particularité, ladite structure multicouches comporte au moins une couche transparente permettant de laisser passer un flux lumineux et un ensemble encapsulant dans lequel sont encapsulées lesdites cellules photovoltaïques.

Selon une variante possible de réalisation, les moyens de détection de présence comportent au moins une caméra de type infrarouge.

Selon une autre variante possible de réalisation, les moyens de détection de présence comportent au moins une cellule photoélectrique.

Selon une autre variante possible de réalisation, les moyens de détection de présence comportent au moins un capteur de type inductif.

Selon une autre variante possible de réalisation, les moyens de détection de présence comportent au moins un capteur de type piézoélectrique positionné sous au moins une zone de signalisation ou intégré à ladite zone de signalisation.

Certaines des variantes de réalisation des moyens de détection pourront avantageusement être combinées entre elles pour améliorer l'efficacité du système.

Selon une particularité, le système comporte un organe de commande manuelle connecté sur une entrée de l'unité de traitement et de commande.

De manière avantageuse, le système comporte des moyens de détection de l'arrivée d'un véhicule à proximité de la zone circulable connectés sur au moins une entrée de l'unité de traitement et de commande.

De manière avantageuse, le système comporte un capteur de luminosité connecté sur une entrée de l'unité de traitement et de commande et en ce que l'unité de traitement et de commande comporte un module de détermination de l'intensité d'éclairage de chaque zone de signalisation en fonction de données reçues du capteur de luminosité.

Selon une autre particularité, le système comporte une séquence de commande exécutée par l'unité de traitement et de commande en fonction de données reçues sur chaque entrée et agencée pour déterminer des signaux de commande à destination du système de commande.

La séquence de commande peut être mise en œuvre selon plusieurs variantes distinctes, utilisées seules ou en combinaison :
- la séquence de commande est agencée pour commander l'allumage des zones de signalisation de manière simultanée ;
- la séquence de commande est agencée pour commander l'allumage des zones de signalisation de manière séquentielle, une zone de signalisation après l'autre ;
- la séquence de commande est agencée pour commander l'allumage des zones de signalisation de manière séquentielle, une zone de signalisation après l'autre, après détection d'une présence par lesdits moyens de détection ;
- la séquence de commande est agencée pour commander l'allumage de chaque zone de signalisation de manière instantanée ou progressive ;
- la séquence de commande est agencée pour commander un allumage des zones de signalisation de manière progressif dans une ou plusieurs couleurs en tenant compte d'une information liée au sens d'arrivée d'un véhicule et/ou à la vitesse d'un véhicule.

### Brève description des figures

D'autres caractéristiques et avantages vont apparaître dans la description détaillée qui suit faite en regard des dessins annexés dans lesquels :
- La figure 1 représente, vue en perspective, une dalle de signalisation lumineuse conforme à l'invention ;
- Les figure 2A et 2B illustrent, par une vue en coupe, la structure multicouches de la dalle de signalisation lumineuse de l'invention, selon deux variantes possibles de réalisation ;
- Les figures 3A et 3B représentent deux réalisations possibles de la dalle de signalisation lumineuse de l'invention ;
- La figure 4 illustre, par une vue en coupe, un exemple de disposition de dalles de signalisation lumineuse sur une chaussée ;
- Les figures 5A et 5B représentent deux exemples de mise en oeuvre des dalles de signalisation lumineuse conformes à l'invention ;
- La figure 6 représente, en vue de dessus, un passage pour piétons classique ;
- La figure 7 représente de manière schématique un système de passage pour piétons amélioré ;
- La figure 8 représente de manière schématique les zones photovoltaïques du système de passage pour piétons optimisé de la figure 7 et l'architecture électrique employée pour stocker l'énergie électrique générée ;
- La figure 9 représente de manière schématique les zones de signalisation du système de passage pour piétons amélioré de la figure 7 et l'architecture de commande employée ;
- La figure 10 représente de manière schématique un exemple de structure multicouches d'une zone photovoltaïque employée dans le système de passage pour piétons amélioré de la figure 7 ;
- La figure 11 illustre un exemple de dimensionnent possible d'un système de passage pour piétons tel que celui de la figure 7 ;
- Les figures 12A à 12C illustrent différentes séquences de commande mises en oeuvre dans le système de passage pour piétons amélioré de la figure 7;

### Description détaillée d'au moins un mode de réalisation

Dans la suite de la description, de manière non limitative, par "zone circulable", on entend toute zone prévue pour la circulation de piétons et/ou de vélos, et/ou de véhicules, telle que par exemple une chaussée de type route ou autoroute, une piste cyclable, un trottoir, un quai ou un parking.

L'invention concerne une dalle de signalisation lumineuse, pouvant également être appelée dalle d'éclairage 2. Elle est par exemple destinée à former en tout ou partie une zone circulable. La zone circulable formée pourra comporter une ou plusieurs dalles de signalisation lumineuse positionnées de manière adaptée pour définir au moins un marquage lumineux sur la zone circulable lorsque leur ensemble lumineux est activé. Les dalles 2 pourront être positionnées de manière jointives ou isolées les unes des autres, selon le marquage ou l'élément d'éclairage à réaliser.

Dans la suite de la description, les termes "avant", "arrière", "supérieur", "inférieur", "haut", "bas" ou autres termes équivalents sont à considérer en tenant compte d'un axe (A) qui sera défini comme perpendiculaire au plan formé par une dalle (axe vertical dans le plan de la feuille sur les figures annexées).

La dalle de signalisation lumineuse 2 peut être positionnée de manière à recouvrir au moins en partie la surface d'une couche de support 1, cette couche de support 1 pouvant être par exemple la chaussée existante ou une couche inférieure de celle-ci, après retrait de la couche de roulement. Cette couche de support 1 est par exemple composée d'un enrobé. Bien entendu, cette couche de support 1 ne faisant pas partie de la dalle de signalisation lumineuse, toute autre structure monocouche ou multicouches pourra être envisagée. Cette couche de support 1 peut faire partie de l'infrastructure globale qui sera décrite ci-dessous.

L'invention vise notamment à réaliser une couche fonctionnelle de signalisation lumineuse ou d'éclairage à l'aide d'une ou plusieurs dalles de signalisation lumineuse positionnées de manière adaptée pour recouvrir au moins partiellement la face supérieure 10 de la couche de support 1.

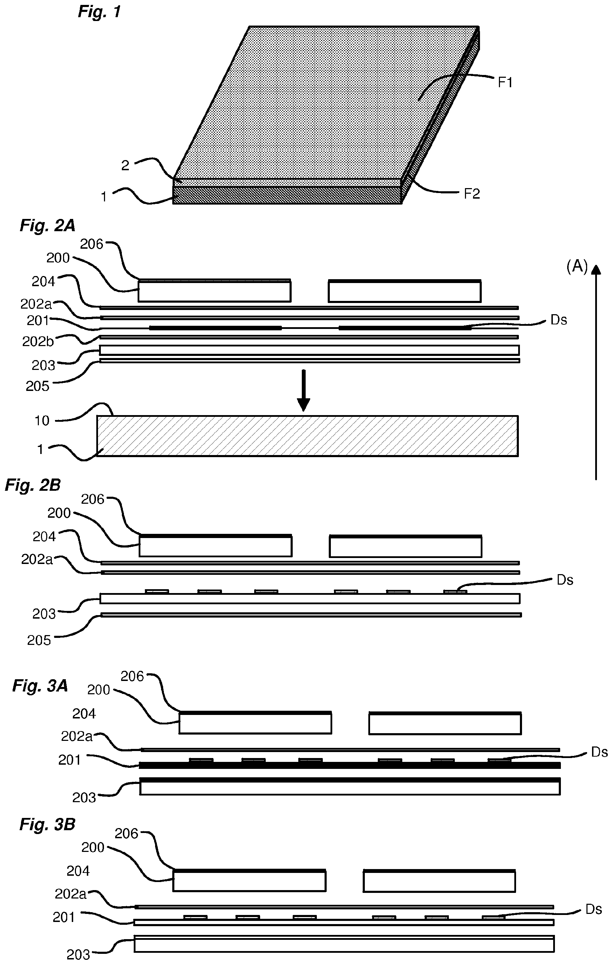

En référence à la figure 1, une dalle de signalisation lumineuse 2 de l'invention comporte les caractéristiques décrites ci-dessous.

La dalle 2 de l'invention se présente sous la forme d'un élément monobloc, c'est-à-dire ne formant qu'une seule pièce. Elle présente avantageusement une première face, dite face supérieure F1, destinée à former sa face externe et une face inférieure F2 opposée et préférentiellement parallèle à la face supérieure. Entre ses deux faces, la dalle comporte plusieurs couches. La dalle 2 peut présenter un contour de toutes formes possibles selon son application. La dalle peut notamment être de forme rectangulaire ou carrée, par exemple de dimensions égales à 20cmx20cm. Bien entendu, selon le type de signalisation à effectuer, elle peut présenter d'autres dimensions. A titre d'exemple et de manière non limitative, elle peut être de 0,1m x 1.5m ou 0,1m x 3m dans une application de type ligne discontinue sur une chaussée, 0,5m x 1,2m ou 0,5m x 2,4 m dans le cas d'une application de type passage piétons.

En référence aux figures 2A et 2B, de l'avant vers l'arrière, chaque dalle de signalisation lumineuse 2 peut comporter une structure multicouches telle que décrite ci-dessous. Certaines couches décrites ci-dessous peuvent être optionnelles.

### Première couche "avant"

La première couche 200 comporte une ou plusieurs plaques ou films transparents juxtaposés. La réalisation en plusieurs plaques ou films juxtaposés permet de gérer les contraintes de dilatation thermique au cours de l'utilisation de la dalle en extérieur. La dilatation étant proportionnelle aux dimensions de cette première couche, utiliser des plaques de dimensions appropriées permet de s'adapter aux contraintes thermiques et d'éviter l'apparition de phénomènes de type délamination ou déformation.

La première couche 200 est réalisée dans un matériau transparent ou translucide de manière à laisser passer un flux lumineux.

Par le terme "transparent", on entend que le matériau formant la première couche est au moins partiellement transparent à la lumière visible, laissant passer par exemple au moins 80% de la lumière visible.

Par le terme « translucide », on entend que le matériau formant la première couche permet la transmission de la lumière visible de manière diffuse.

Par ailleurs, la première couche peut être teintée dans toute couleur, selon l'application visée.

La première couche 200 peut être réalisée dans un matériau de type polymère choisi parmi le polycarbonate (PC), le polyméthacrylate de méthyle (PMMA), l'éthylène tétrafluoroéthylène (ETFE) et le polyfluorure de vinylidène (PVDF). Avantageusement, il s'agira d'un matériau de type polycarbonate.

La première couche 200 peut présenter une épaisseur supérieure à 100µm et avantageusement comprise entre 200 µm et 3200 µm et de préférence entre 400 µm et 750 µm.

De manière non limitative, la première couche 200 est composée d'un film de polycarbonate poli, traité contre les rayons ultra-violets et d'une épaisseur de 450 µm.

Chaque plaque de la première couche 200 peut être positionnée en vis-à-vis d'une ou plusieurs diodes électroluminescentes Ds de l'ensemble lumineux décrit ci-dessous.

### Ensemble lumineux

L'ensemble lumineux 201 est composé de plusieurs diodes électroluminescentes Ds connectées en série et/ou parallèle.

Les diodes électroluminescentes Ds peuvent émettre dans différentes couleurs.

Des moyens de conversion peuvent être employés pour émettre dans une teinte souhaitée.

Une même dalle de signalisation lumineuse 2 peut émettre des signaux lumineux de plusieurs couleurs (soit en employant des diodes électroluminescentes aux couleurs souhaitées ou des moyens de conversion adaptés).

Selon la densité lumineuse souhaitée, les diodes électroluminescentes Ds peuvent être espacées d'une distance allant de 0.5cm à 30 cm et de préférence d'une distance comprise entre 0.6 cm et 15 cm.

Les diodes électroluminescentes Ds peuvent être assemblées en rubans déposés sur un support ou connectées sur un support (circuit imprimé) permettant d'alimenter les diodes et comprenant par exemple des rubans de conducteurs sur époxy ou kapton sur lesquels viennent se connecter les diodes électroluminescentes Ds.

Sur un même ruban, les diodes Ds peuvent être espacées d'un pas compris entre 0.5 cm et 10 cm et de préférence compris entre 1 cm et 3 cm. La distance inter-rubans peut être comprise entre 1 cm et 30 cm et de préférence compris entre 2 cm et 15 cm.

Ce support des diodes électroluminescentes peut compléter la deuxième couche "arrière" 203 décrite ci-après ou se substituer à cette couche.

Le support peut présenter une épaisseur comprise entre 0,1 mm et 5 mm, avantageusement comprise entre 0,1 mm et 2 mm, idéalement comprise entre 0,15 mm et 1,5mm.

Des moyens de commande de l'éclairage des diodes Ds, localisés dans la dalle et/ou centralisés dans un coffret externe, sont bien entendu prévus pour commander l'ensemble lumineux 201 de manière adaptée à la signalisation à effectuer. Ces moyens de commande peuvent comporter un automate programmable comprenant des entrées/sorties. L'automate peut recevoir des informations en provenance de différents capteurs sur ses entrées et commande de manière adaptée les dalles de signalisation lumineuse connectées sur ses sorties.

Avantageusement, l'espacement entre deux plaques voisines de la première couche 200 est inférieur ou égal à l'espacement entre deux diodes électroluminescentes Ds voisines. Ainsi, au moins chaque plaque de la première couche 200 est placée en vis-à-vis d'au moins une diode électroluminescente Ds.

### Ensemble encapsulant

La structure comporte un ensemble encapsulant ou boîtier dans lequel est encapsulé l'ensemble lumineux qui comporte les diodes électroluminescentes Ds.

Par le terme "encapsulant" ou "encapsulé" employé, il faut comprendre que les diodes électroluminescentes Ds sont logées dans un volume, préférentiellement hermétique.

Il permet de combler l'espacement présent entre les diodes électroluminescentes Ds de l'ensemble lumineux 201.

L'ensemble encapsulant peut comporter une partie supérieure 202a et éventuellement une partie inférieure 202b.

La partie supérieure 202a est positionnée entre la première couche 200 et l'ensemble lumineux 201.

La partie supérieure 202a forme une protection mécanique telle une coquille sur l'ensemble lumineux.

La partie supérieure 202a peut comporter un niveau de rigidité exprimé par un module de Young à température ambiante supérieur à 50 MPa.

Avantageusement, la partie supérieure 202a de l'ensemble encapsulant est réalisée dans un matériau de type ionomère présentant un module de Young supérieur à 300 MPa.

Dans un mode particulier de réalisation, la partie inférieure 202b de l'ensemble encapsulant est située entre l'ensemble lumineux 201 et la deuxième couche 203 décrite ci-dessous.

La partie inférieure 202b forme une protection mécanique et une barrière à l'eau ou humidité susceptible de remonter par le dessous de la dalle.

La partie inférieure 202b peut comporter un niveau de rigidité exprimé par un module de Young à température ambiante supérieur à 50 MPa.

Avantageusement, la partie inférieure 202b de l'ensemble encapsulant est réalisée dans un matériau de type ionomère présentant un module de Young supérieur à 300MPa.

Chaque élément réalisé sous la forme d'un film destiné à former la partie supérieure et éventuellement la partie inférieure de l'ensemble encapsulant peut présenter une épaisseur comprise entre 0,1 mm et 2 mm, idéalement comprise entre 0,3 mm et 1,5 mm.

Dans sa totalité (une ou deux couches), ledit ensemble encapsulant peut présenter une épaisseur comprise entre 100 µm et 4 mm et avantageusement comprise entre 250 µm et 1 mm.

### Deuxième couche "arrière"

La deuxième couche 203 forme la couche inférieure de la structure et constitue le support de la dalle de signalisation lumineuse 2.

Cette deuxième couche 203 est réalisée dans un matériau destiné à assurer une protection mécanique contre le poinçonnement arrière des circuits électroniques de l'ensemble lumineux 201 lorsque la dalle de signalisation lumineuse 2 est soumise à une charge mécanique importante.

La deuxième couche 203 peut être dotée d'une rigidité exprimée par un module de Young à température ambiante supérieur à 1 GPa, avantageusement supérieur ou égal à 3 GPa, idéalement supérieur à 10 GPa.

La deuxième couche 203 est cependant suffisamment flexible pour s'adapter aux déformations de la couche de support 1 de la chaussée.

La deuxième couche est suffisamment souple pour se conformer aux déformations de la chaussée (bosse ou creux de 1 cm tous les 20 cm, avantageusement bosse ou creux de 0,5 cm tous les 20 cm, idéalement bosse ou creux de 0,2 cm tous les 20 cm).

La deuxième couche 203 peut être réalisée dans un matériau transparent ou opaque, et éventuellement teintée, par exemple dans la masse ou en surface notamment pour définir un motif.

La deuxième couche 203 peut présenter une épaisseur comprise entre 0,1mm et 10mm, avantageusement comprise entre 0,4mm et 5mm, avantageusement comprise entre 1 mm et 3 mm.

La deuxième couche 203 peut être réalisée dans un matériau polymère, dans un matériau composite, par exemple de type polymère/fibres de verre ou dans un matériau de la famille des polymères thermodurcissables, tel que les résines de type phénol-formaldéhyde.

De manière non limitative, la deuxième couche 203 peut être composée par exemple d'un matériau composite de type polymère/fibres de verre tel qu'un tissu à base de polytéréphtalate d'éthylène, de polypropylène ou de polyépoxyde et de fibres de verre avec un taux de fibres de verre, par exemple compris entre 20% et 70% en masse.

Cette deuxième couche 203 peut présenter un coefficient de dilatation thermique inférieur ou égal à 20 ppm, de préférence inférieur ou égal à 10 ppm.

Selon une variante de réalisation, cette deuxième couche 203 peut être réalisée sous la forme d'une carte de circuit imprimé sur laquelle sont connectées directement les diodes électroluminescentes Ds. Cette couche arrière fait donc office de support des diodes électroluminescentes et les protège du côté arrière. Seule la couche supérieure de l'ensemble encapsulant pourra alors être nécessaire. La figure 2B illustre une telle architecture dans laquelle la couche arrière 203 fait directement office de support des diodes électroluminescentes. La couche arrière 203 peut alors être une carte de circuit imprimé La couche de protection 202a est présente pour protéger les diodes électroluminescentes du côté avant et la couche arrière 203 les protège du côté arrière. Les autres couches de la structure sont par exemple identiques.

### Couches de compatibilité et de protection

La structure peut comporter une ou plusieurs couches de compatibilité et de protection, appelées couches intermédiaires.

Dans un mode de réalisation, la structure peut comporter une première couche intermédiaire 204 positionnée entre la première couche 200 et la partie supérieure 202a de l'ensemble encapsulant.

La structure peut également comporter une deuxième couche intermédiaire (non représentée) positionnée entre la deuxième couche 203 et la partie inférieure 202b de l'ensemble encapsulant.

Chacune de ces couches intermédiaires peut être nécessaire en cas d'incompatibilité chimique entre la première couche et la deuxième couche et le matériau d'encapsulation.

Chaque couche intermédiaire peut être réalisée dans un matériau encapsulant standard et choisi par exemple parmi un polymère de type caoutchouc ou élastomère comme l'éthylène acétate de vinyle (EVA), une polyoléfine, la silicone, un polyuréthane thermoplastique et le polyvinyle de butyral. Elle peut également être réalisée à partir d'une résine liquide de type acrylique, silicone ou polyuréthane (mono-composant ou bi-composant), réticulable à chaud ou à froid.

De manière non limitative, à titre d'exemple :
- Pour la première couche intermédiaire, il peut s'agir de l'association d'un ou de plusieurs films d'EVA présentant une épaisseur totale comprise entre 200 µm et 1600 µm ;
- Pour la deuxième couche intermédiaire, il peut s'agir d'un ou plusieurs films en TPU) présentant une épaisseur totale comprise entre 200 µm et 1500 µm ;

La première couche intermédiaire 204 peut présenter des propriétés de déformabilité en vue de conférer à la dalle un certain niveau d'amortissement. Dans ce cas, cette couche aura une double fonction de compatibilité et d'amortissement. Elle permettra également de combler le vide entre les diodes électroluminescentes Ds.

Chaque couche intermédiaire peut présenter une rigidité définie par un module de Young à température ambiante inférieur ou égal à 100 MPa.

Chaque couche intermédiaire peut présenter une épaisseur comprise entre 0,01 mm et 1 mm.

### Couche adhésive de la dalle

La structure peut comporter une couche adhésive 205 située en face arrière de la dalle et en contact avec la deuxième couche 203 et permettant de coller la dalle sur la surface 10 de la couche de support 1. Cette couche adhésive peut être formée d'une colle ou d'un matériau polymère adhésif, par exemple de type double face.

Cette colle peut être une colle permettant de faire adhérer la dalle à la couche de support 1. Cette colle peut être à base de résine MMA (Méthacrylate de Méthyle), éventuellement additivée de charges, ou de type bitumeuse, appliquée à des dosages allant de 0,5 à 10 kg/m².

L'utilisation d'une colle associée à la deuxième couche 203 réalisée en matériau composite peut permettre de renforcer la face arrière de la dalle et éviter les risques de poinçonnement des diodes électroluminescentes Ds lorsqu'elles sont soumises à des charges mécaniques importantes.

### Couche de roulement

La couche de roulement peut recouvrir une ou plusieurs dalles de signalisation lumineuse. Pour une seule dalle, elle peut recouvrir toutes les plaques de la première couche de manière continue ou recouvrir chaque plaque de manière indépendante, formant des discontinuités sur la dalle 2.

Pour chaque dalle, la couche de roulement 206 vient recouvrir la première couche 200 pour conférer à la dalle 2 une certaine rugosité et des caractéristiques d'adhérence.

La couche de roulement 206 peut être composée d'une résine transparente ou translucide et d'éléments texturants irréguliers permettant de conférer à la dalle une certaine adhérence, même dans des conditions humides.

La résine peut être de type acrylique, époxy ou polyuréthane. La résine peut être déposée avec un dosage compris entre 10 et 1000 g/m2, avantageusement compris entre 30 et 700 g/m2, avantageusement compris entre 150 et 600 g/m2.

La couche de roulement est éventuellement additivée d'une substance colorée (par exemple une peinture routière blanche ou jaune, ou encore des pigments de TiO2, ou une peinture jaune), à laquelle on ajoute des éléments texturants transparents ou colorés, par exemple des grains de verre, d'une taille comprise entre 0,01 et 4 mm, mieux comprise entre 0,1 et 2 mm, idéalement comprise entre 0,2 et 1,8 mm. Le dosage de ces grains de verre est compris entre 10 et 800 g/m², mieux 30 et 500 g/m², idéalement 50 et 400 g/m². La colorimétrie peut être mesurée selon les normes NF EN 1871 ou NF EN 1436, et s'inscrire dans le périmètre chromatique d'un marquage, par exemple la norme NF EN 1436+A1 pour un marquage routier blanc. Les résines employées se doivent d'être transparentes ou translucides, et de bien adhérer à la fois à la première couche des dalles ainsi qu'aux éléments texturants.

La couche de revêtement peut présenter un taux de transparence permettant de faire passer au moins 10% du flux lumineux généré par l'ensemble lumineux 201, avantageusement 50% à 95% du flux lumineux généré par l'ensemble lumineux 201.

En tenant compte des différentes couches décrites ci-dessus, de manière avantageuse, une dalle de signalisation lumineuse 2 peut comporter la structure multicouches suivante, en allant de l'avant vers l'arrière de la dalle :
- Une première couche 200 formée d'un film de 450 µm d'épaisseur réalisé en polycarbonate poli et traité anti-UV ;
- Une couche amortissante 204 formée d'un ou plusieurs films d'EVA ayant une épaisseur choisie entre 200 et 1600 µm et d'un ou plusieurs films thermoplastiques en TPU à une épaisseur comprise entre 200 µm et 1500 µm ;
- Une couche supérieure 202a d'encapsulant formée d'un ionomère présentant une rigidité définie par le module de Young supérieure à 300 MPa et choisie à une épaisseur comprise entre 100 µm et 500 µm ;
- Un ensemble lumineux 201 composé de diodes électroluminescentes Ds assemblés en rubans ou sur un circuit imprimé, avec un espacement entre diodes pouvant aller de 0,5 à 30 cm ;
- Une deuxième couche 203 formée à l'arrière et composée d'un polymère composite de type tissu à base de polytéréphtalate d'éthylène, de polypropylène ou de polyépoxyde et de fibres de verre avec un taux de fibres de verre, par exemple compris entre 20% et 70% en masse et de préférence entre 50% et 70% en masse, présentant une épaisseur de 1,5mm et un module de Young égal à 12 GPa. Comme déjà noté ci-dessus, cette deuxième couche 203 peut être réalisée sous la forme d'un circuit imprimé et faire directement office de support pour les diodes électroluminescentes Ds.
- Une couche de roulement 206 telle que décrite ci-dessus ;

Selon un aspect particulier de l'invention, chaque dalle 2 peut, selon son état, présenter une couleur distincte. Ainsi, de manière non limitative, en référence aux figures 3A et 3B, on a les configurations suivantes :
- Lorsque son ensemble lumineux 201 est éteint, sa couleur peut être foncée, de couleur proche de celle du reste de la chaussée. Dans ce cas, la deuxième couche 203 arrière et/ou le support de l'ensemble lumineux peut être coloré dans cette couleur foncée (il peut notamment s'agir directement de la carte de circuit imprimé sur laquelle sont connectées les diodes électroluminescentes). Lorsque la dalle est éteinte, rien ne la distingue du reste de la chaussée (figure 3A). Il s'agira ainsi de colorer la deuxième couche "arrière" 203 d'une couleur adaptée. Il sera possible d'y déposer de la peinture (par exemple une peinture Griffon noire en épaisseur comprise entre 0,001 et 1 mm), ou en intercalant un film de polymère coloré (par exemple un EVA noir), ou en pigmentant, par exemple avec du noir de carbone, soit totalement dans sa masse, soit uniquement dans les parties supérieures. Cette dernière réalisation est particulièrement adaptée aux couches "arrière" réalisées en plusieurs plis : seuls les plis supérieurs sont pigmentés, pour peu impacter le coût ou les propriétés mécaniques.
- Lorsque son ensemble lumineux 201 est éteint, sa couleur peut être claire, par exemple blanche ou jaune. L'allumage de son ensemble lumineux permet alors de la rendre encore plus visible. Dans ce cas, la deuxième couche 203 arrière et/ou le support de l'ensemble lumineux peut être coloré dans cette couleur blanche ou jaune (par exemple une peinture Griffon ou à base PU blanche en épaisseur comprise entre 0,001 et 1 mm). Lorsque la dalle est éteinte, le marquage reste visible. Cette solution permet de garder le marquage visible, même en cas de dysfonctionnement de la dalle (figure 3B). Il est également possible d'intercaler un film translucide ou un tissé en PET blanc au-dessus de l'ensemble lumineux 201 et/ou d'ajouter des pigments (par exemple du TiO2) ou peinture au sein de la résine constitutive de la couche de roulement (par exemple ajout à une résine acrylique type Verniroc entre 0,5 et 50 % de peinture blanche Griffon, mieux entre 1 et 30 %, idéalement entre 1 et 20 %).

Bien entendu, selon les applications visées, toute autre couleur peut être envisagée, que ce soit dans l'état actif ou inactif de la dalle de signalisation lumineuse.

Selon un autre aspect de l'invention, les diodes électroluminescentes peuvent éclairer dans plusieurs couleurs distinctes pour réaliser des affichages dynamiques sur une chaussée. De manière non limitative, il peut s'agir d'indications de limitation de vitesse (par exemple modifiées selon les conditions climatiques), d'indications de places de stationnement pour livraison (rouge sur une certaine plage horaire et vert le reste du temps), d'indications de type zebra ou zigzag pour arrêt de bus (changeant de couleur selon la durée d'attente à prévoir) ou de tout autre marquage.

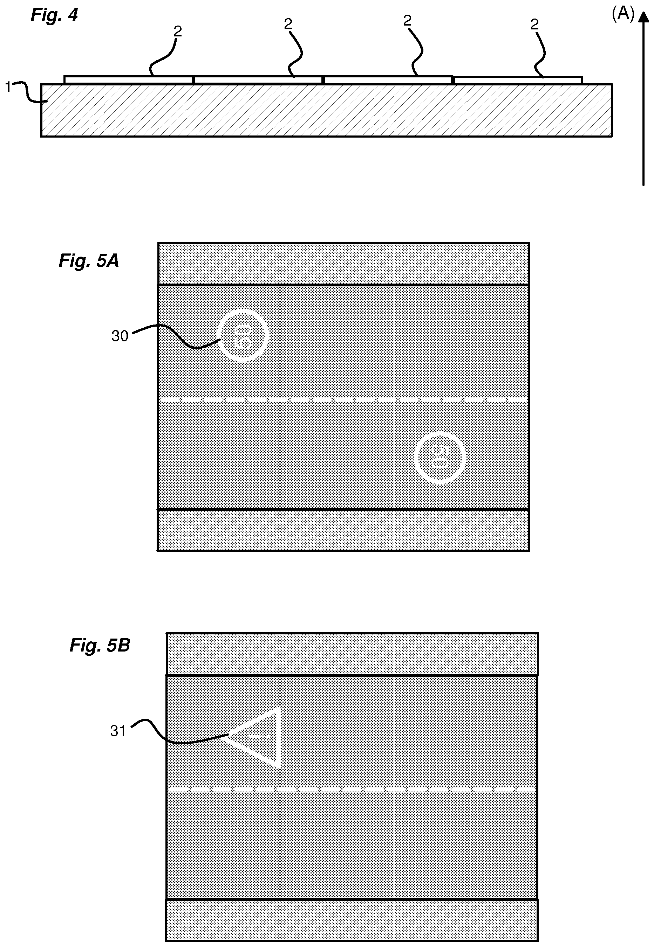

Selon un aspect de l'invention, comme représenté sur la figure 4, une ou plusieurs dalles de signalisation lumineuse 2 telles que décrites ci-dessus peuvent être positionnées sur la surface 10 d'une couche de support 1 afin de former une zone circulable. Lesdites dalles peuvent former tous types de marquage ou message, habituellement présents sur une zone circulable, notamment :
- Marquage formant une ligne continue ou discontinue sur une route ;
- Passage piétons ;
- Zébra délimitant une zone d'arrêt, par exemple pour taxi ou bus ;
- Marquage de bord signalant une zone dangereuse ;
- Signalisation de vitesse sur la chaussée ;
- Marquage pour signaler une zone de ralentissement, un danger ;
- Marquage de guidage ;
- Indications précises de type horaires de passage du prochain bus ou durée d'attente à prévoir ;
- Indications à caractères informatif, culturel, publicitaire ;

Les figures 5A et 5B illustrent quelques exemples de marquage qu'il est possible de réaliser à l'aide d'une ou plusieurs dalles de signalisation lumineuse conformes à l'invention. Sur la figure 5A, le marquage lumineux 30 consiste en une signalisation de vitesse à respecter, indiquant que l'on peut circuler sur cette voie à la vitesse indiquée. Sur la figure 5B, le marquage lumineux 31 consiste en la signalisation d'un danger.

Une ou plusieurs dalles de signalisation lumineuse pourront être commandées de manière séquencée afin de créer des effets de type chenillard ou avec une intensité variable.

La dalle de signalisation lumineuse 2 présente ainsi un certain nombre d'avantages, parmi lesquels :
- Une épaisseur très faible, pouvant être inférieure à 10mm ;
- Une résistance mécanique importante pour supporter toute charge mécanique, notamment le passage de voitures ou camions ;
- Un grand degré de flexibilité, lui permettant de s'adapter aux défauts de surface de sa couche de support 1 ;
- Un haut niveau d'éclairage, permettant d'assurer une signalisation performante dans toutes les situations ;
- Une résistance aux intempéries accrues grâce à un encapsulage adapté des circuits électroniques ;
- Grâce à sa faible épaisseur, une installation facilitée, même sur une chaussée existante ;

La dalle de signalisation lumineuse a été décrite ci-dessus pour un système comprenant une zone circulable dotée d'une couche de support 1. Cependant, l'invention peut être mise en œuvre pour de nombreuses autres applications, notamment toute application qui requièrent des éléments fins, flexibles et/ou robustes vis-à-vis des chocs ou charges mécaniques ou encore de résister au vandalisme.

De manière non limitative, un système de passage pour piétons peut employer une ou plusieurs desdites dalles de signalisation lumineuse décrites ci-dessus.

La figure 6 représente un passage pour piétons PP' classiques. Il comporte typiquement plusieurs bandes blanches 10' identiques de dimensions réglementées et espacées entre elles d'une distance déterminée. Elles sont agencées parallèlement entre elles et orientées dans leur sens longitudinal, suivant la direction de circulation des véhicules sur la chaussée 12'. Elles sont réparties sur toute la largeur de la chaussée d'un trottoir T1 à l'autre T2 (si bien entendu des trottoirs sont présents). Une ligne blanche 11' (en pointillés sur la figure 6) permet de délimiter les deux voies sur la chaussée et les deux sens de circulation.

Un système de passage pour piétons amélioré, représenté sur les figures annexées, comporte notamment deux aspects principaux. Il dispose de moyens d'éclairage, lui permettant de rester visible, même en cas de faible ou forte luminosité et il est autonome en énergie électrique, c'est-à-dire qu'il n'est pas utile de raccorder ses moyens d'éclairage au réseau électrique puisqu'il est autoalimenté. De manière avantageuse, tout surplus d'électricité produit pourra être renvoyé sur le réseau électrique R. Le système comporte alors des moyens spécifiques pour assurer un transfert de l'énergie électrique produite vers le réseau électrique R, par exemple mais pas uniquement lorsque l'unité de stockage propre du système est pleine. Il s'agira par exemple de pouvoir employer également les zones photovoltaïques ZP pour envoyer de l'énergie électrique sur le réseau R lorsque celui-ci est en demande, que l'unité de stockage électrique soit pleine ou non.

Un tel système 1 de passage pour piétons comporte notamment une zone circulable délimitée sur laquelle les véhicules peuvent circuler et les piétons peuvent traverser. Cette zone circulable se compose d'une couche fonctionnelle réalisée avantageusement en plusieurs parties, qui est déposée sur une couche inférieure, typiquement un enrobé ou directement sur la surface de roulement (un bitume) de la chaussée. Dans le premier cas, une découpe aux dimensions de la zone circulable pourra s'avérer nécessaire. Dans le deuxième cas, la couche fonctionnelle étant d'une épaisseur très faible, par exemple inférieure à 10mm, celle-ci ne génère aucune contrainte pour la circulation des véhicules ou des piétons.

La couche fonctionnelle se distingue d'une couche standard de roulement déposée sur l'enrobé en ce qu'elle permet de fonctionnaliser la chaussée et de lui apporter des moyens d'interaction, notamment visuels, commandés à partir d'informations reçues par des moyens de détections déterminés, explicités ci-après.

Selon un aspect de l'invention, la zone circulable du système de passage pour piétons de l'invention est avantageusement constituée uniquement de :
- Zones photovoltaïques ZP ;
- Zones de signalisation ZS ;

En référence à la figure 7, les zones photovoltaïques ZP et les zones de signalisation ZS sont avantageusement disposées les unes à côté des autres pour former toute la zone circulable et pour former un passage pour piétons ayant le même aspect visuel qu'un passage pour piétons classique (tel que représenté sur la figure 6). Les zones de signalisation ZS sont donc préférentiellement réalisées sous la forme de bandes rectangulaires de dimensions règlementées (largeur de 0,50m, longueur L comprise entre 2,5m et 6 mètres) espacées entre elles par des bandes rectangulaires plus sombres d'un écartement normalisé (compris entre 0,50m et 0,80m.), formant les zones photovoltaïques ZP. Les dimensions évoquées ci-dessus sont données à titre d'exemple et sont bien entendu susceptibles d'évoluer selon les lois en vigueur.

La zone circulable ainsi formée est positionnée dans la continuité de la chaussée classique, sans aucune transition. Son épaisseur particulièrement faible lui permet dans tous les cas d'être à un niveau similaire à celui de la surface de roulement de la chaussée située en amont et en aval. Bien entendu, certains passages pour piétons étant surélevés, il serait possible de la surélever de manière adaptée par rapport au niveau de la surface de roulement de la chaussée située en amont et en aval.

Selon un aspect particulier du système, chaque zone photovoltaïque ZP sera par exemple formée d'une ou plusieurs dalles de dimensions identiques et positionnées de manière adjacente et jointive pour couvrir toute la zone photovoltaïque. De même, chaque zone de signalisation ZS pourra être formée d'une ou plusieurs dalles de dimensions identiques positionnées de manière adjacente et jointive pour couvrir toute la zone de signalisation.

Les dalles des zones de signalisation et les dalles des zones photovoltaïques sont avantageusement positionnées de manière adjacente et jointive afin de former toute la surface de la couche fonctionnelle du système de l'invention.

Les dalles de type photovoltaïques et les dalles lumineuses des zones de signalisation sont avantageusement d'une épaisseur identique pour permettre une installation aisée de la zone circulable.

Selon un aspect particulier du système, les bandes sombres qui séparent les zones de signalisation sont donc avantageusement formées par les zones photovoltaïques ZP. Ces bandes sombres sont avantageusement d'une longueur L identique à celle utilisée pour les bandes des zones de signalisation et présentent une largeur qui est par exemple supérieure à celles des bandes des zones de signalisation, allant par exemple de 0,70m à 1m. Bien entendu, les zones photovoltaïques ZP pourraient être positionnées sur d'autres parties de la chaussée. Cependant, il est particulièrement avantageux de regrouper à la fois les zones photovoltaïques et les zones de signalisation dans un périmètre délimité, afin de créer une unique couche fonctionnelle dans ce périmètre. A titre d'exemple, chaque zone photovoltaïque ayant des dimensions de 2,8mX0,7m présente une puissance de 240 Watts crête.

En référence à la figure 7, on a donc une alternance entre les zones photovoltaïques ZP et les zones de signalisation ZS. Selon la largeur de la route (entre les deux trottoirs T1 et T2), on aura ainsi plusieurs zones de signalisation ZS et plusieurs zones photovoltaïques ZP disposées en alternance, avantageusement sur toute la largeur de la route. Avantageusement, chaque zone photovoltaïque ZP ou les dalles qui la composent et chaque zone de signalisation ou les dalles qui la composent, sont réalisés sous la forme d'éléments monoblocs qu'il est possible de poser directement sur l'enrobé. Seules les connexions électriques sont alors à réaliser vers les différentes unités du système.

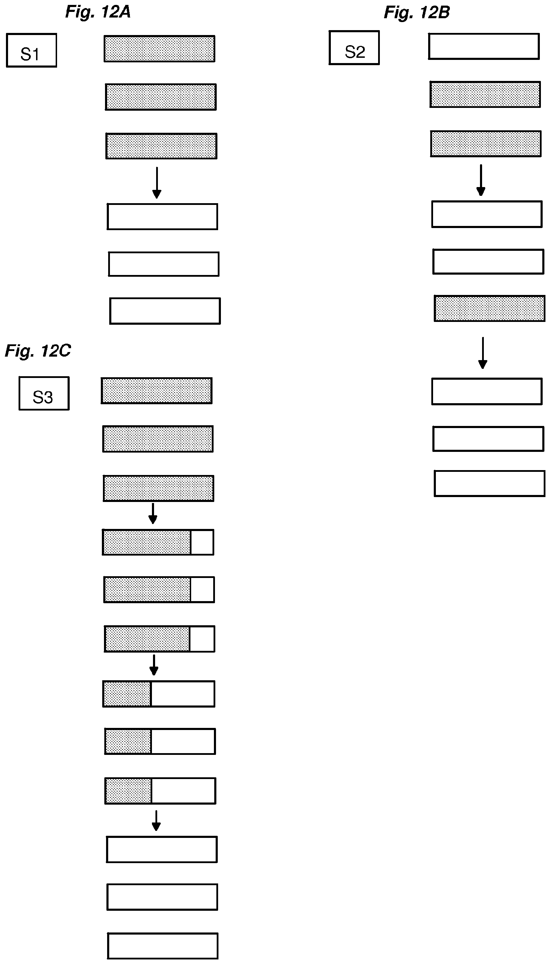

Selon un aspect particulièrement avantageux du système, les zones photovoltaïques sont dimensionnées de manière adaptée pour alimenter toutes les zones de signalisation. On aura par exemple une zone photovoltaïque dimensionnée pour assurer l'alimentation d'au moins une zone de signalisation. De cette manière, quelle que soit la largeur de la chaussée, on sera sûr que toutes les zones de signalisation pourront être alimentées en énergie électrique. Un exemple de dimensionnement sera notamment décrit ci-après en liaison avec la figure 12.

Selon un autre aspect avantageux du système, le câblage électrique sera également facilité car les zones photovoltaïques et les zones de signalisation pourront être agencées pour partager les mêmes passages de câbles.

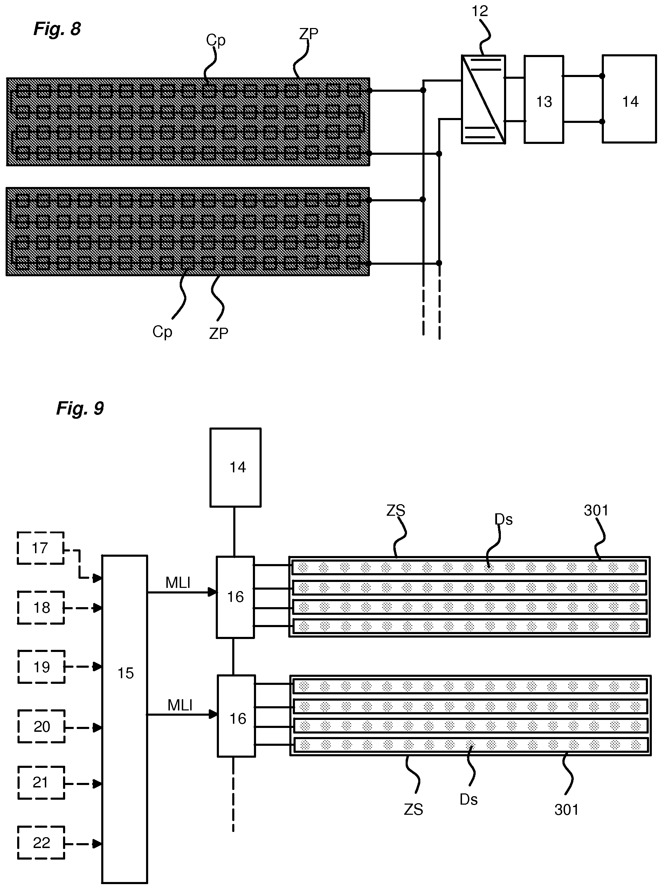

De manière plus précise, les zones photovoltaïques ZP comportent chacune des cellules photovoltaïques destinées à convertir une énergie lumineuse en une énergie électrique. Les cellules photovoltaïques Cp sont connectées entre elles selon une topologie classique telle qu'on la retrouve dans un module photovoltaïque. A titre d'exemple et de manière non limitative, en référence à la figure 8, l'architecture photovoltaïque qui inclut les zones photovoltaïques présente les particularités suivantes :
- Chaque zone photovoltaïque ZP comporte plusieurs rangées de cellules photovoltaïques Cp, connectées en série et/ou en parallèle ;
- Un convertisseur 12 (ici DC/DC) est avantageusement connecté à l'ensemble des zones photovoltaïques ZP pour assurer une conversion électrique vers une unité de stockage d'énergie électrique 14 à travers un chargeur 13 de batterie ;
- Des moyens de commande, intégrés ou non au convertisseur, sont aptes à commander le convertisseur pour effectuer la conversion de tension ;
- Chaque zone photovoltaïque comporte avantageusement des diodes de contournement (dites de "bypass" - non représentées) pour contourner chacune une rangée de cellules distinctes d'une zone si une cellule de cette rangée était en défaut ;

Le convertisseur 12 pourra être logé dans une cavité réalisée dans la chaussée et fermée par une trappe ou dans une armoire électrique positionnée à proximité de la couche fonctionnelle réalisée.

Selon un aspect particulier, le système de passage pour piétons comporte également une unité de stockage d'énergie électrique 14, destinée à stocker l'énergie électrique générée par les cellules photovoltaïques des zones photovoltaïques. Cette unité de stockage d'énergie électrique 14 comporte par exemple une ou plusieurs batteries. Le chargeur 13 de batteries et le convertisseur 12 décrits ci-dessus sont commandés pour assurer la charge de l'unité de stockage d'énergie électrique 14 par l'énergie électrique générée par les zones photovoltaïques ZP. L'énergie électrique stockée dans cette unité de stockage d'énergie électrique 14 sera employée pour alimenter :
- Les moyens d'éclairage des zones de signalisation ZS, c'est-à-dire les diodes électroluminescentes ;
- Une unité de traitement et de commande 15, à travers un module d'alimentation ALIM ;
- Différents moyens de détection évoqués ci-après, sauf si ceux-ci sont autoalimentés ;
- Eventuellement l'unité de commande de du convertisseur 12 si elle est présente ;
- Tout autre capteur ou solution de détection nécessitant une alimentation électrique ;

De manière avantageuse, par exemple lorsque l'unité de stockage 14 est pleine, tout surplus d'électricité généré par les zones photovoltaïques ZP pourra être transféré vers le réseau électrique R, celui-ci devenant alors une extension de l'unité de stockage 14. Cependant, le transfert d'électricité vers le réseau R pourra être réalisé à tout moment, notamment en cas de demande en énergie électrique de la part du réseau électrique. Les zones photovoltaïques ZP pourront alors être également employées dans ce but. De même, en cas de demande du réseau R, il pourra s'agit de décharger l'unité de stockage d'énergie électrique du système. Le système sera donc à même de fonctionner dans une installation de type "Smart Grid".

De manière non limitative, chaque zone photovoltaïque ZP comporte une structure telle que celle décrite dans les deux demandes de brevet n°WO2016/16165A1 et WO2016/16170A1 et représentée sur la figure 9. Cette structure de la zone photovoltaïque sera avantageusement semi-rigide, c'est-à-dire présentant un degré déformabilité en flexion pouvant aller jusqu'à 30% par rapport à la forme initiale.

Sans rentrer dans les détails, cette structure comporte une première couche 400 transparente sur toute son épaisseur de manière à laisser passer un flux lumineux. Par le terme "transparent", on entend que le matériau formant la première couche est au moins partiellement transparent à la lumière visible.

La première couche 400 sera par exemple réalisée sous la forme d'une seule plaque ou de plusieurs plaques juxtaposées. Elle sera par exemple réalisée dans un matériau polymère transparent, tel que par exemple du polyméthacrylate de Méthyle (PMMA) ou du polycarbonate.

La structure de la zone photovoltaïque comporte un ensemble encapsulant dans lequel sont encapsulées les cellules photovoltaïques. Cet ensemble encapsulant est préférentiellement constituée de deux couches 402a, 402b de matériau d'encapsulation, entre lesquelles les cellules photovoltaïques sont encapsulées. Une opération de laminage est mise en œuvre pour fondre les deux couches 402a, 402b d'encapsulation en une seule couche dans laquelle sont noyées les cellules photovoltaïques Cp. Le procédé de fabrication est détaillé dans les deux demandes de brevet cités ci-dessus. Celui-ci ne faisant pas partie de l'invention, il n'est pas décrit précisément dans la présente demande.

Par le terme "encapsulant" ou "encapsulé" employé, il faut comprendre que les cellules photovoltaïques Cp sont logées dans un volume, préférentiellement hermétique, formé par l'assemblage des deux couches de l'ensemble.

La structure de la zone photovoltaïque comporte une deuxième couche 403, formant sa face arrière. L'ensemble encapsulant est positionné entre la première couche 200 et cette deuxième couche 403. Cette deuxième couche 403 sera par exemple réalisée dans un matériau de type composite, par exemple de type polymère/fibres de verre.

La structure de la zone photovoltaïque comporte avantageusement une couche intermédiaire 404 dite "amortissante" située entre la première couche 400 et la couche supérieure 402a de l'ensemble encapsulant (402a, 402b) et permettant l'assemblage, notamment par collage, de la première couche 400 sur l'ensemble encapsulant.

La structure de la zone photovoltaïque comporte avantageusement une couche adhésive (non représentée) située entre l'ensemble encapsulant et la deuxième couche 403. Cette couche servira à l'assemblage, notamment par collage, de la deuxième couche 403 sur l'ensemble encapsulant.

La première couche sera avantageusement formée ou recouverte d'une couche de manière à présenter une surface externe dotée de propriétés d'adhérence suffisantes et adaptées à la fois au passage des piétons et à la circulation des véhicules. Il s'agira par exemple de doter la surface externe d'un certain degré de rugosité.

Les cellules photovoltaïques Cp seront avantageusement positionnées sur une couche de couleur sombre (noire ou bleue par exemple) de manière à fournir un contraste suffisant, à travers la couche transparente 400, par rapport aux zones de signalisation.

En référence à la figure 9, les zones de signalisation ZS comportent chacune des moyens d'éclairage, constitués au moins en partie des diodes électroluminescentes Ds présentes dans chaque dalle de signalisation lumineuse.

Les diodes électroluminescentes Ds pourront avantageusement émettre dans différentes couleurs. Des moyens de conversion pourront être avantageusement employés pour émettre dans une teinte proche du blanc, correspondant à la couleur des bandes d'un passage pour piétons. Une même zone de signalisation ZS pourra cependant émettre des signaux lumineux de plusieurs couleurs (soit en employant des diodes électroluminescentes aux couleurs souhaitées ou des moyens de conversion adaptés). A titre d'exemple, les moyens d'éclairage des zones de signalisation ZS permettront d'atteindre un coefficient de luminance ayant une valeur minimale de 130 mcd/m2/lx.

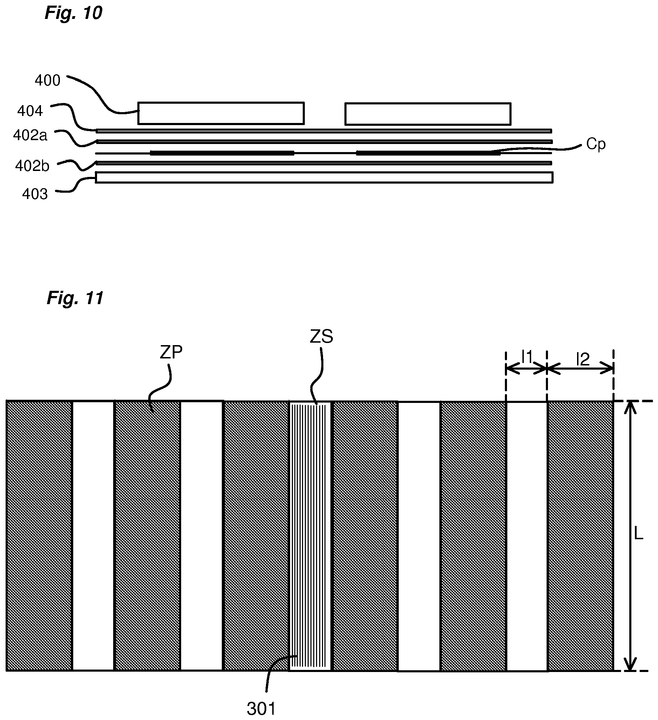

De manière non limitative et en référence à la figure 11, chaque zone de signalisation ZS comporte une structure similaire à celle d'une zone photovoltaïque, les diodes électroluminescentes Ds remplaçant les cellules photovoltaïques.

De manière non limitative et plus précise, chaque zone de signalisation ZS est avantageusement réalisée à partir d'une ou plusieurs dalles de signalisation lumineuse telles que décrites ci-dessus en liaison avec les figures 1 à 4. De telles dalles de signalisation lumineuse peuvent ainsi être positionnées de manière adjacentes et jointives afin de former la surface externe de la zone de signalisation ZS et former ainsi chaque bande de signalisation du passage pour piétons. Toutes les caractéristiques techniques des dalles de signalisation lumineuse décrites ci-dessus en liaison avec les figures 1 à 4 sont transposables, sans modification, pour une utilisation dans le système de passage pour piétons décrit en liaison avec les figures 7 à 9.

Les diodes électroluminescentes Ds employés seront avantageusement assemblées sur un support se présentant sous la forme d'un ruban (301-figure 8) ou d'un circuit imprimé optimisé. De manière non limitative, chaque ruban 301 se présente par exemple sous la forme d'une carte de circuit imprimé réalisée en matériau souple ou rigide.

Dans la zone de signalisation ZS, les diodes électroluminescentes Ds sont agencées pour apporter un éclairage suffisant permettant de toujours visualiser la zone quelle que soit la luminosité ambiante. De manière non limitative, plusieurs variantes d'agencement peuvent être proposées :
- Une première variante consiste à disposer les diodes électroluminescentes sur le contour de la zone pour le délimiter. Il s'agira alors par exemple de disposer des rubans 301 de diode suivant les deux longueurs et les deux largeurs de la zone. L'intérieur de la zone, délimité par les diodes électroluminescentes, restera dans une teinte blanche et sans diode.
- Une deuxième variante consiste à couvrir la majorité de la zone de signalisation ZS. Il s'agira par exemple de disposer plusieurs rubans en parallèle (comme sur la figure 9), chaque ruban 301 étant de la largeur ou de la longueur de la bande formée par la zone de signalisation, de manière à couvrir toute la zone de signalisation ZS ;
- Une troisième variante consiste par exemple à disposer les diodes électroluminescentes de manière à pouvoir afficher un message particulier lorsqu'elles sont éclairées. Il s'agira alors de former des lettres ou un symbole particulier en allumant les diodes des rubans 301 ;
- Une quatrième variante est adaptée au passage pour piétons surélevés. Dans cette configuration des rubans de diodes électroluminescentes sont par exemple positionnés sur le contour des zones de signalisation et notamment sur les parties latérales inclinées permettant la surélévation ;

Le système de passage pour piétons comporte également une unité de traitement et de commande 15. Cette unité de traitement et de commande 15 est par exemple formée d'un automate programmable comportant un module unité centrale UC et plusieurs modules d'entrées/sorties, ci-après désignées entrées et sorties (référencés IN et OUT sur la figure 7) de l'unité de traitement et de commande 15. Le module unité centrale UC comporte avantageusement un microprocesseur et des moyens de mémorisation. Cette unité de traitement et de commande 15 comporte également un module d'alimentation ALIM recevant une alimentation électrique de l'unité de stockage d'énergie électrique. L'unité de traitement et de commande 15 pourra également comporter un module de communication COM permettant à l'automate de se connecter sur un réseau de communication (filaire ou sans fil) pour récupérer tous types d'informations, telles que mises à jour, statistiques... Il pourra s'agir également de connecter plusieurs systèmes entre eux, par exemple au sein d'une même ville, à travers un réseau de communication, afin de partager des informations.

En référence à la figure 9, le système comporte également un système de commande des moyens d'éclairage des zones de signalisation. Ce système de commande se compose avantageusement de plusieurs unités de pilotage (16 - "driver") associés chacune à une ou plusieurs diodes électroluminescentes, préférentiellement à au moins un ruban de diodes électroluminescentes ou à tous les rubans d'une même zone de signalisation, pour les commander à l'allumage, à l'extinction et/ou en intensité... Les unités de pilotage 16 du système de commande sont avantageusement intégrées aux zones de signalisation ZS, au plus proche des diodes électroluminescentes commandées. Elles sont connectées sur une ou plusieurs sorties (OUT) de l'unité de traitement et de commande 15 afin de recevoir des signaux de commande (par exemple de type MLI - Modulation de Largeur d'Impulsions) adaptés à la séquence de commande exécutée par l'unité de traitement et de commande 15.

Le système comporte également des moyens de détection de présence connectés sur une ou plusieurs entrées de l'unité de traitement et de commande. Ces moyens de détection de présence sont destinés à détecter la présence d'un ou plusieurs piétons en passe de s'engager sur le passage pour piétons.

En référence à la figure 7, ces moyens de détection de présence peuvent être mis en œuvre selon plusieurs variantes (indiquées en pointillés sur la figure 7), prises seules ou en combinaison :
- Une caméra 17 de type infra-rouge, par exemple positionnée en haut d'un mat et pointant en direction du passage pour piétons pour détecter une présence. Cette solution présente l'avantage de fonctionner même en cas de faible luminosité. Une caméra sera par exemple disposée sur chaque trottoir T1, T2 aux abords de la chaussée.
- Une solution à cellule photoélectrique ou à plusieurs cellules photoélectriques, par exemple agencées sous la forme d'une barrière lumineuse 18 générant un faisceau lumineux (en pointillés sur la figure 7) entre un émetteur et un récepteur. Cette solution sera idéalement placée au bord de la chaussée, juste en amont du passage pour piétons. Cette solution sera avantageusement intégrée dans le mobilier urbain, par exemple dans les plots habituellement positionnés sur les deux trottoirs T1, T2 opposés.
- Une solution de type piézoélectrique comprenant un ou plusieurs capteurs piézoélectriques 22 positionnés sous les zones de signalisation et/ou sous les zones photovoltaïques. Ils pourront également être intégrés aux zones de signalisation, aux dalles podotactiles parfois positionnées aux abords des passages piétons, ou aux zones photovoltaïques, par exemple logés dans les ensembles encapsulant les cellules photovoltaïques ou les diodes électroluminescentes.

Sur la figure 7, il faut bien entendu comprendre que certains moyens de détection sont optionnels et que tous ne seront pas forcément employés dans un même système.

Par ailleurs, de manière optionnelle, le système pourra également comporter au moins un organe manuel de commande 19 (préférentiellement deux, situés sur les deux trottoirs T1, T2 opposés) connecté sur une entrée de l'unité de traitement et de commande et destiné à actionner manuellement le système, c'est-à-dire à activer les zones de signalisation ZS selon une séquence de commande déterminée (voir ci-après).

De manière optionnelle, le système pourra également comporter des moyens de détection de l'arrivée d'un véhicule à proximité de la zone circulable, connectés sur au moins une entrée de l'unité de traitement et de commande. Ces moyens de détection comportent par exemple une boucle de mesure inductive 20 formée sur chaque voie de la chaussée, en amont du passage pour piétons, permettant ainsi d'indiquer dans quel sens arrive un véhicule. Tout autre moyen de détection de ce type pourrait être envisagé, par exemple une mesure laser, permettant en complément de déterminer la vitesse du véhicule. Chaque boucle devra être positionnée suffisamment en amont du passage pour piétons pour permettre à un piéton qui s'engage de bien réceptionner l'information. Il s'agira notamment de tenir compte de la limitation de vitesse appliquée autour du passage pour piétons (pour une limitation de vitesse de 30km/h et en vue d'assurer un délai d'avertissement de 5s entre le moment où la voiture est détectée et le moment où elle doit être au niveau du passage pour piétons, les moyens de détection devront être positionnés à une distance D de 41,50 mètres par rapport au passage pour piétons).

De manière optionnelle, le système peut également comporter un capteur de luminosité 21, destiné à déterminer le niveau de luminosité aux abords du passage pour piétons. De manière non limitative, ce capteur sera par exemple intégré à la zone circulable du passage pour piétons, positionné sur l'armoire électrique qui intègre les appareils électriques de gestion du système ou au niveau du mât qui porte la caméra infrarouge.

Ces différentes options seront avantageusement alimentées par l'énergie électrique stockée dans l'unité de stockage d'énergie électrique 14. Mais il faut également comprendre que tous les capteurs évoqués ci-dessus pourront être également autoalimentés, intégrant par exemple de générateur d'énergie de tous types (piézoélectrique, photovoltaïque, électromagnétique, thermique...). Par ailleurs, certains des capteurs seront avantageusement sans-fil. La liaison avec l'unité de traitement et de commande 15 sera alors réalisée à travers un réseau de communication sans-fil, par exemple de type Zigbee pour limiter la consommation d'énergie du capteur.

Dès la réception d'un signal sur une ou plusieurs de ces entrées, l'unité de traitement et de commande 15 active l'éclairage des zones de signalisation du système en envoyant des signaux de commande adaptés au système de commande des diodes électroluminescentes Ds.

Selon un aspect particulier du système, l'unité de traitement et de commande 15 met en œuvre une séquence de commande des zones de signalisation.

En fonction de la présence ou non des différentes solutions de détection décrites ci-dessus, différentes séquences de commande pourront être envisagées. Il est à noter que l'unité de traitement et de commande 15 pourra avantageusement stocker dans ses moyens de mémorisation plusieurs séquences distinctes, le choix de la séquence à exécuter étant fonction des données rendues disponibles sur ses entrées, et/ou des informations reçues sur ses entrées en provenance des différents capteurs.

Les figures 12A à 12C représentent certaines séquences de commande possibles. Sur ces figures, la couleur grise indique que les zones de signalisation sont éteintes et la couleur blanche indique que ces zones sont allumées. La séquence de commande exécutée par l'unité de traitement et de commande pourra ainsi commander l'éclairage des zones de signalisation ZS selon les différents modes suivants, pris seuls ou en combinaison :
- En commandant l'allumage de chaque zone de signalisation de manière instantanée - Séquence S1, figure 12A ;
- En commandant un allumage progressif de chaque zone de signalisation ;
- En commandant un allumage de toutes les zones de signalisation en même temps - Séquence S1, figure 12A ;
- En commandant un allumage d'une zone après l'autre, par exemple en tenant compte de l'avancée du piéton (soit selon une temporisation préenregistrée en fonction de la vitesse moyenne d'un piéton, soit en tenant compte des informations reçues des capteurs piézoélectriques positionnés au niveau des zones ou en tenant compte de toute autre information obtenue par tout autre moyen) - Séquence S2, figure 12B ;
- En commandant un allumage variable des zones de signalisation tout au long d'une journée ou à chaque passage, pour tenir compte des variations de luminosité ;
- En commandant un allumage variable des zones de signalisation, en activant certaines diodes électroluminescentes d'une zone de signalisation ou de plusieurs zones de signalisation. Il s'agira par exemple de maintenir un niveau d'éclairage minimal lorsque la luminosité est faible et d'augmenter progressivement le nombre de diodes électroluminescentes activé pour tenir compte de la hausse de luminosité afin de maintenir toujours les zones de signalisation bien visibles ;
- En commandant un allumage des diodes de manière à afficher un message particulier, par exemple lié à l'arrivée imminente d'un véhicule ;
- En commandant un allumage des diodes de manière ciblée, par exemple progressif suivant le sens d'arrivée d'un véhicule sur le passage pour piétons détecté grâce aux capteurs 20. En cas de danger, il s'agira par exemple de commander un éclairage en rouge - Séquence S3, Figure 12C ;

### Exemple de réalisation et dimensionnement :

De manière non limitative, en référence à la figure 11, le système de l'invention comportant une alternance de zones photovoltaïques et de zones de signalisation présente par exemple les caractéristiques suivantes :
   - Cinq zones de signalisation ZS et six zones photovoltaïques ZP ;
   - Densité d'éclairage sans diffuseur en face avant :
      - Une zone de signalisation ZS : largeur l1 0,5m x Longueur L 2,8m ;
      - Rubans 301 de diodes électroluminescentes alignées, découpés à la longueur voulue (densité de trente diodes électroluminescentes Ds par mètre de ruban) et disposés dans le sens de la longueur de la zone, les rubans étant espacés d'un pas constant de 3,3cm dans le sens de la largeur de la zone ;
      - Treize rubans 301 de 2,5m de long par zone de signalisation ZS ;
   - Puissance d'éclairage :
      - Donnée constructeur : 2,4W/m
      - Puissance d'une zone de signalisation à luminosité max : 2,4 x 2,6 x 13 = 81W/zone
      - Soit une puissance totale de : 5 x 81 = 405W pour l'ensemble des cinq zones de signalisation ;
   - Puissance photovoltaïque disponible :
      - Six zones photovoltaïques de largeur l2 0,7m x Longueur L 2,8m
      - Puissance Photovoltaïque : 240Wc /zone → Puissance Totale : 1440Wc
   - Dimensionnement batterie (unité de stockage d'énergie électrique 14) :
      - 1h/jour à 100% → 500Wh/jour
      - Autonomie souhaitée sans soleil : 3 jours → 1500Wh sous 12V → 125Ah
      - Batteries installées : 2 fois 90Ah soit 180Ah soit un peu plus de quatre jours d'autonomie.

On comprend de ce qui précède que ce système de passage pour piétons présente un certain nombre d'avantages, parmi lesquels :
- Une facilité d'installation, les zones photovoltaïques et les zones de signalisation se présentant avantageusement sous la forme de dalles à juxtaposer ;
- Une autonomie en énergie électrique, permise par l'emploi des zones photovoltaïques ;
- Des solutions différentes d'animations des zones de signalisation, qui permettent de tenir compte de différentes conditions de fonctionnement et de différentes situations ;
- Un gain en encombrement non négligeable, les zones de signalisation et les zones photovoltaïques destinées à leur alimentation étant réalisées directement dans la zone circulable ;

## Revendications

1. Dalle de signalisation lumineuse (2) monobloc comprenant une structure à plusieurs couches superposées et fixées entre elles, ladite structure comportant:
- Une première couche (200) transparente ou translucide formant une face avant de ladite dalle ;
- Un ensemble lumineux (201) comprenant une pluralité de diodes électroluminescentes (Ds) reliées électriquement entre elles ;
- Un ensemble encapsulant (202a, 202b) ladite pluralité de diodes électroluminescentes ; **caractérisée en ce que** ladite structure comporte encore:
- Une deuxième couche (203) formant une face arrière de ladite dalle et composée d'un matériau polymère ou composite de type polymère/fibres de verre ;
- Ledit ensemble encapsulant étant positionné entre ladite première couche (200) et ladite deuxième couche (203).

2. Dalle de signalisation lumineuse selon la revendication 1, **caractérisée en ce que** chaque plaque de la première couche (200) est positionnée en vis-à-vis d'au moins une diode électroluminescente (Ds).

3. Dalle de signalisation lumineuse selon la revendication 1 ou 2, **caractérisée en ce que** la première couche (200) est réalisée dans un matériau de type polymère choisi parmi le polycarbonate, le polyméthacrylate de méthyle, l'éthylène tétrafluoroéthylène et le polyfluorure de vinylidène.

4. Dalle de signalisation lumineuse selon l'une des revendications 1 à 3, **caractérisée en ce que** la première couche (200) présente une épaisseur supérieure à 100 µm, avantageusement comprise entre 200 µm et 3200 µm et de préférence entre 400 µm et 750 µm.

5. Dalle de signalisation lumineuse selon l'une des revendications 1 à 4, **caractérisée en ce que** la deuxième couche (203) présente une rigidité définie par un module de Young à température ambiante supérieur à 1 GPa.

6. Dalle de signalisation lumineuse selon l'une des revendications 1 à 5, **caractérisée en ce que** ladite deuxième couche (203) comporte une épaisseur comprise entre 0.3 mm et 3 mm.

7. Dalle de signalisation lumineuse selon l'une des revendications 1 à 6, **caractérisée en ce que** les diodes électroluminescentes (Ds) sont organisées en ruban déposé sur la deuxième couche (203) ou sur un support, ou sont connectées sur une carte de circuit imprimé.

8. Dalle de signalisation lumineuse selon l'une des revendications 1 à 7, **caractérisée en ce que** ladite deuxième couche est réalisée sous la forme d'une carte de circuit imprimé sur laquelle sont connectées directement lesdites diodes électroluminescentes.

9. Dalle de signalisation lumineuse selon l'une des revendications 1 à 8, **caractérisée en ce que** l'ensemble encapsulant (202a, 202b) est réalisé dans un matériau présentant un module de Young à température ambiante supérieur à 50MPa.

10. Dalle de signalisation lumineuse selon l'une des revendications 1 à 9, **caractérisée en ce que** ledit ensemble encapsulant présente une épaisseur comprise entre 100 µm et 4 mm et avantageusement comprise entre 250 µm et 1 mm.

11. Dalle de signalisation lumineuse selon l'une des revendications 1 à 10, **caractérisée en ce que** la structure multicouches comporte au moins une couche intermédiaire (204), agencée entre ladite première couche et l'ensemble encapsulant et configurée pour réaliser l'assemblage par collage de ladite première couche sur l'ensemble encapsulant.

12. Dalle de signalisation lumineuse selon la revendication 11, **caractérisée en ce que** ladite couche intermédiaire (204) est réalisée dans un ou plusieurs matériaux choisis parmi une polyoléfine, des polymères de type caoutchouc, élastomère ou époxy.

13. Dalle de signalisation lumineuse selon la revendication 12, **caractérisée en ce que** la couche intermédiaire (204) est configurée pour présenter un module de Young à température ambiante inférieur ou égal à 100 MPa.

14. Dalle de signalisation lumineuse selon la revendication 12 ou 13, **caractérisée en ce que** ladite couche intermédiaire (204) comporte une épaisseur comprise entre 200 µm et 1600 µm.

15. Dalle de signalisation lumineuse selon l'une des revendications 1 à 14, **caractérisée en ce que** ladite structure comporte une couche adhésive (205) située en face arrière, en contact avec la deuxième couche.

16. Dalle de signalisation lumineuse selon l'une des revendications 1 à 15, **caractérisée en ce que** ladite structure comporte une couche de roulement (206) appliquée sur ladite première couche (200), ladite couche de roulement étant non opaque et présentant une surface texturée et irrégulière.

17. Système comprenant une zone circulable dotée d'une couche de support (1), **caractérisé en ce qu'**il comporte une ou plusieurs dalles de signalisation lumineuse (2) telles que définie dans l'une des revendications précédentes fixées sur ladite couche de support (1), chaque dalle de signalisation lumineuse étant positionnée de manière à former un marquage sur ladite zone circulable lorsque leur ensemble lumineux est allumé.

## Patentansprüche

1. Einstückige Lichtsignalisierungsplatte (2) mit einer Struktur aus mehreren übereinanderliegenden und untereinander befestigten Schichten, wobei die Struktur
- eine durchsichtige oder durchscheinende, eine Vorderseite der Platte bildende erste Schicht (200),
- eine Leuchteinheit (201) mit einer Anzahl elektrisch untereinander verbundener Leuchtdioden (Ds),
- ein die Anzahl Leuchtdioden umschließendes Gebilde (202a, 202b) aufweist,
**dadurch gekennzeichnet, daß** die Struktur außerdem
- eine eine Rückseite der Platte bildende und aus einem Polymermaterial oder einem Komposit des Typs Polymer/Glasfasern zusammengesetzte zweite Schicht (203)
aufweist,
- wobei das umschließende Gebilde zwischen der ersten Schicht (200) und der zweiten Schicht (203) positioniert ist.

2. Lichtsignalisierungsplatte gemäß Anspruch 1, **dadurch gekennzeichnet, daß** jede Platte der ersten Schicht (200) gegenüber wenigstens einer Leuchtdiode (Ds) positioniert ist.

3. Lichtsignalisierungsplatte gemäß Anspruch 1 oder 2, **dadurch gekennzeichnet, daß** die erste Schicht (200) aus einem Material vom Typ Polymer hergestellt ist, das unter dem Polykarbonat, dem Polymethylmethacrylat, dem Ethylen-Tetrafluorethylen und dem Polyvinylidenfluorid ausgewählt ist.

4. Lichtsignalisierungsplatte gemäß einem der Ansprüche 1 bis 3, **dadurch gekennzeichnet, daß** die erste Schicht (200) eine Dicke von mehr als 100 µm, vorteilhafterweise zwischen 200 µm und 3200 µm und vorzugsweise zwischen 400 µm und 750 µm aufweist.

5. Lichtsignalisierungsplatte gemäß einem der Ansprüche 1 bis 4, **dadurch gekennzeichnet, daß** die zweite Schicht (203) eine durch das Young-Modul bei Zimmertemperatur definierte Steifigkeit von mehr als 1 GPa aufweist.

6. Lichtsignalisierungsplatte gemäß einem der Ansprüche 1 bis 5, **dadurch gekennzeichnet, daß** die zweite Schicht (203) eine Dicke zwischen 0,3 mm und 3 mm aufweist.

7. Lichtsignalisierungsplatte gemäß einem der Ansprüche 1 bis 6, **dadurch gekennzeichnet, daß** die Leuchtdioden (Ds) als auf die zweite Schicht (203) oder auf eine Unterlage aufgebrachtes Band organisiert sind oder auf einer Karte mit gedruckter Schaltung verbunden sind.

8. Lichtsignalisierungsplatte gemäß einem der Ansprüche 1 bis 7, **dadurch gekennzeichnet, daß** die zweite Schicht in Form einer Karte mit gedruckter Schaltung ausgeführt ist, auf der die Leuchtdioden direkt verbunden sind.

9. Lichtsignalisierungsplatte gemäß einem der Ansprüche 1 bis 8, **dadurch gekennzeichnet, daß** das umschließende Gebilde (202a, 202b) aus einem Material gefertigt ist, das ein Young-Modul bei Zimmertemperatur von mehr als 50 MPa aufweist.

10. Lichtsignalisierungsplatte gemäß einem der Ansprüche 1 bis 9, **dadurch gekennzeichnet, daß** das umschließende Gebilde eine Dicke zwischen 100 µm und 4 mm und vorteilhafterweise zwischen 250 µm und 1 mm aufweist.

11. Lichtsignalisierungsplatte gemäß einem der Ansprüche 1 bis 10, **dadurch gekennzeichnet, daß** die Mehrschichtstruktur wenigstens eine Zwischenschicht (204) aufweist, die zwischen der ersten Schicht und dem umschließenden Gebilde angeordnet ist und dazu ausgelegt ist, ein Zusammenfügen durch Kleben der ersten Schicht auf das umschließende Gebilde auszuführen.

12. Lichtsignalisierungsplatte gemäß Anspruch 11, **dadurch gekennzeichnet, daß** die Zwischenschicht (204) aus einem oder mehreren unter einem Polyolefin, Polymeren vom Typ Gummi, Elastomer oder Epoxid ausgewählten Materialien ausgeführt ist.

13. Lichtsignalisierungsplatte gemäß Anspruch 12, **dadurch gekennzeichnet, daß** die Zwischenschicht (204) dazu ausgelegt ist, ein Young-Modul bei Zimmertemperatur von kleiner als oder gleich 100 MPa aufzuweisen.

14. Lichtsignalisierungsplatte gemäß Anspruch 12 oder 13, **dadurch gekennzeichnet, daß** die Zwischenschicht (204) eine Dicke zwischen 200 µm und 1600 µm aufweist.

15. Lichtsignalisierungsplatte gemäß einem der Ansprüche 1 bis 14, **dadurch gekennzeichnet, daß** die Struktur eine auf der Rückseite angeordnete, mit der zweiten Schicht in Kontakt befindliche Haftschicht (205) aufweist.

16. Lichtsignalisierungsplatte gemäß einem der Ansprüche 1 bis 15, **dadurch gekennzeichnet, daß** die Struktur eine auf die erste Schicht (200) aufgebrachte Rollschicht (206) aufweist, wobei die Rollschicht nicht undurchsichtig ist und eine texturierte und unregelmäßige Oberfläche aufweist.

17. System mit einer mit einer Trägerschicht (1) versehenen begehbaren Zone, **dadurch gekennzeichnet, daß** es eine oder mehrere wie in einem der vorangehenden Ansprüche definierte Lichtsignalisierungsplatten (2) aufweist, die auf der Trägerschicht (1) befestigt sind, wobei jede Lichtsignalisierungsplatte so positioniert ist, daß sie eine Markierung auf der begehbaren Zone bildet, wenn deren Leuchteinheit eingeschaltet ist.

## Claims

1. A luminous signaling slab (2) of integral construction having a structure made up of a plurality of superposed layers that are fastened to one another, said structure comprising:
- A transparent or translucent first layer (200) forming a front face of said slab;
- A luminous assembly (201) comprising a plurality of light-emitting diodes (Ds) that are electrically connected to one another;
- An encapsulating assembly (202a, 202b) encapsulating said plurality of light-emitting diodes;
**characterized in that** said structure further comprises:
- A second layer (203) forming a rear face of said slab and composed of a polymer or a polymer/glass-fiber composite material;
- Said encapsulating assembly being positioned between said first layer (200) and said second layer (203).

2. The luminous signaling slab as claimed in claim 1, **characterized in that** each tile of the first layer (200) is positioned facing at least one light-emitting diode (Ds).

3. The luminous signaling slab as claimed in claim 1 or 2, **characterized in that** the first layer (200) is made from a polymer material chosen from polycarbonate, polymethyl methacrylate, ethylene tetrafluoroethylene and polyvinylidene fluoride.

4. The luminous signaling slab as claimed in one of claims 1 to 3, **characterized in that** the first layer (200) has a thickness larger than 100 µm, advantageously comprised between 200 µm and 3200 µm and preferably between 400 µm and 750 µm.

5. The luminous signaling slab as claimed in one of claims 1 to 4, **characterized in that** the second layer (203) has a stiffness defined by a Young's modulus at room temperature higher than 1 GPa.

6. The luminous signaling slab as claimed in one of claims 1 to 5, **characterized in that** said second layer (203) has a thickness comprised between 0.3 mm and 3 mm.

7. The luminous signaling slab as claimed in one of claims 1 to 6, **characterized in that** the light-emitting diodes (Ds) are organized in a ribbon deposited on the second layer (203) or on a carrier, or are connected to a printed circuit board.

8. The luminous signaling slab as claimed in one of claims 1 to 7, **characterized in that** said second layer is produced in the form of a printed circuit board to which said light-emitting diodes are directly connected.

9. The luminous signaling slab as claimed in one of claims 1 to 8, **characterized in that** the encapsulating assembly (202a, 202b) is made from a material having a Young's modulus at room temperature higher than 50 MPa.

10. The luminous signaling slab as claimed in one of claims 1 to 9, **characterized in that** said encapsulating assembly has a thickness comprised between 100 µm and 4 mm and advantageously comprised between 250 µm and 1 mm.

11. The luminous signaling slab as claimed in one of claims 1 to 10, **characterized in that** the multilayer structure comprises at least one intermediate layer (204), arranged between said first layer and the encapsulating assembly and configured to join said first layer to the encapsulating assembly by adhesive bonding.

12. The luminous signaling slab as claimed in claim 11, **characterized in that** said intermediate layer (204) is made from one or more materials chosen from a polyolefin, epoxy, elastomer or rubber polymers.

13. The luminous signaling slab as claimed in claim 12, **characterized in that** the intermediate layer (204) is configured to have a Young's modulus at room temperature lower than or equal to 100 MPa.

14. The luminous signaling slab as claimed in claim 12 or 13, **characterized in that** said intermediate layer (204) has a thickness comprised between 200 µm and 1600 µm.

15. The luminous signaling slab as claimed in one of claims 1 to 14, **characterized in that** said structure comprises an adhesive layer (205) located on the rear face, making contact with the second layer.

16. The luminous signaling slab as claimed in one of claims 1 to 15, **characterized in that** said structure comprises a tread layer (206) applied onto said first layer (200), said tread layer being non-opaque and having a textured and irregular surface.

17. A system comprising a trafficable zone equipped with a base layer (1), **characterized in that** it comprises one or more luminous signaling slabs (2) such as defined in one of the preceding claims, fastened onto said base layer (1), each luminous signaling slab being positioned so as to form a marking on said trafficable zone when the luminous assembly thereof is turned on.
